# EUROPEAN PATENT SPECIFICATION

(11) **EP 1 627 413 B1**
(45) Date of publication and mention of the grant of the patent: **28.01.2009**
(21) Application number: 04733521.1
(22) Date of filing: 18.05.2004
(51) Int. Cl.: H01J 37/32, H05H 1/46

(54) **A HIGH DENSITY PLASMA REACTOR**
PLASMAREAKTOR FÜR HOHE DICHTEN
REACTEUR A PLASMA A HAUTE DENSITE

(30) Priority: 22.05.2003 EP 03405360
(43) Date of publication of application: 22.02.2006
(73) Proprietor: HELYSSEN S.à.r.l., 1020 Renens (CH)
(72) Inventor: CHEVALIER, Eric, 74290 Veyrier de Lac (FR); GUITTIENNE, Philippe, CH-1018 Lausanne (CH)
(74) Representative: Poncet, Jean-François
(86) International application number: PCT/CH2004/000300
(87) International publication number: WO 2004/105078

(56) References cited:
- EP-A- 0 403 418
- WO-A-00/36632
- WO-A-96/19910
- US-A- 4 915 978
- US-A- 5 146 137
- US-A- 6 164 241
- US-A1- 2002 007 794
- PATENT ABSTRACTS OF JAPAN vol. 1998, no. 08, 30 June 1998 (1998-06-30) -& JP 10 070107 A (ULVAC JAPAN LTD), 10 March 1998 (1998-03-10)
- PATENT ABSTRACTS OF JAPAN vol. 2000, no. 08, 6 October 2000 (2000-10-06) & JP 2000 150483 A (C BUI RES:KK), 30 May 2000 (2000-05-30)

## Description

### FIELD OF THE INVENTION

The present invention relates to a method and apparatus for enhancing plasma source and associated processes.

### BACKGROUND OF THE INVENTION

Helicon wave discharges are known to efficiently produce high-density plasma, and have been exploited as a high density plasma tool for semiconductor processing (etching, deposition, sputtering...) [Lieberman M.A., Lichtenberg A.J., Principles of Plasma Discharges and Materials Processing, J. Wiley & Sons, 1994, New York.], space propulsion and basic plasma experiments. The plasma is usually generated in a cylindrical vacuum vessel in a longitudinal homogeneous magnetic field at 100 - 300 G or higher. The electromagnetic energy is transferred to the plasma source with frequencies between 1 and 50 MHz, usually with 13.56 MHz for processing plasmas. Helicon waves are generated in the plasma column by specially-shaped antennas.

The most common antenna used to excite helicon waves is the Nagoya Type III antenna [Okamura S, et al. 1986 Nucl. Fusion 26 1491], a modification of which is the double-saddle coil of Boswell [Boswell R.W. 1984, Plasma Phys. Control. Fusion,26 1147]. Further modifications of this antenna type are disclosed e.g. in EP 0 403 418 A. Helical antennae were first used by Shoji et al., and have been adapted such that single-loop antennae [Sakawa Y., Koshikawa N, Shoji T, 1996 Appl. Phys. Lett. 69 1695 ; Carter C. and Khachan J., 1999 Plasma Sources Sci. Technol. 8 432],double loop antennae [Tynan G.R. et al. 1997 J. Vac. Sci. Technol. A 15 2885 ; Degeling A.W., Jung C.O., Boswell R.W., Ellingboe A.R., 1996 Phys. Plasmas 3 2788], solenoid antennae [Kim J.H., Yun S.M., and Chang H.Y. 1996 Phys. Lett. A 221 94], and bifilar rotating-field antennae[Miljak D.G. and Chen F.F. 1998 Plasma Sources Sci. Technol. 7 61].

The damping of this wave can be explained by collisional theory [Chen F.F., Sudit I.D. and Light M., 1996 Plasma Sources Sci. Technol. 5 173], but collisionless (Landau) damping of helicon waves and the helicon wave transfer through the excitation of another wave at the boundary of the chamber called Trivelpiece-Gould mode has also been discussed [Chen F.F. Physical mechanisms in industrial RF plasma Sources, LTP-104, 2001, UCLA]. The type of discharge achieves electron densities up to 10¹² - 10¹³ cm⁻³ in the 0.1 Pa pressure range.

The main features which define the right antenna structure to excite Helicon waves for generation of plasmas are :
- Frequency of Excitation : It should be such that the waves satisfies : ωci < ω < ωc (ωci = ion cyclotron frequency, ωc = electron cyclotron frequency). Industrial standard frequency such as 13.56MHz are usually used in semiconductor processing.
- Wave mode : the mode structure of the wave electromagnetic fields generated so that an antenna arrangement can best be designed to efficiently couple the RF power into wave excitation. The two lowest modes are m=0 and m=1 modes. The best way to excite the mode m = 0 would be with two loops separated in distance by a half-wavelength. For the mode m=1 there is a natural helical pitch to the electric and magnetic field vectors as the wave propagates along a principal axis. Given the state of the art, the current way to excite this mode is with a helical shaped antenna.
- Efficiency of coupling RF power to plasma : the efficiency of the plasma production depends on the coupling of RF energy into the plasma. An important mechanism for damping of the RF energy is Landau damping. The phase velocity of the helicon wave is given by ω/k_{z} , where k_{z} is given by the dispersion relation and depends on the plasma density and magnetic field strength. Ideally, the phase velocity of the wave should be near the maximum of the ionisation potential of the gas we wish to ionise. The higher the value of k_{z}, the higher the density. But if k_{z} is too high then the energy of the electrons may fall below the ionisation potential. It is therefore important to control k_{z} in order to be able to increase the density and control the electron temperature.

It is known to generate Helicon waves with an apparatus comprises four pairs of electrodes (US patent N°5 146 137, K-H Kretschmer & al.,1992-09-08). A first pair of the electrodes is connected to a first voltage. A second pair of the electrodes is connected to a second voltage. The first voltage is 90.degree phase shifted relative to the second voltage. The first and second pairs of electrodes are mounted on a first region of the container. The third pair of the electrodes and the fourth pair of the electrodes are then mounted on a second region of the container a distance from the first region of the container. The third and fourth pair of electrodes are connected to phase shifted voltages, in a manner similar to the first and second pair of electrodes. In an alternate aspect, the apparatus generate a plasma inside a container using circularly polarized waves by coupling electromagnetic energy into the plasma through the container wall from the outside : The apparatus comprises four coils. A first coil is connected to a first voltage. A second coil is connected to a second voltage. The first voltage is 90.degree. phase shifted relative to the second voltage. The third and fourth coil are connected to phase shifted voltages, in a manner similar to the first and second coil. In yet a third form, the apparatus comprises four pairs of coils. A first pair of the coils is connected to a first voltage. A second pair of the coils is connected to a second voltage. The first voltage is 90.degree phase shifted relative to the second voltage. The first and second pairs of coils are mounted on a first region of the container. The third pair of the coils and the fourth pair of the coils are then mounted on a second region of the container a distance from the first region of the container. The third and fourth pair of coils are connected to phase shifted voltages, in a manner similar to the first and second pairs of coils.

The major differences between the previous apparatus and our invention is that our antenna consists in one coil (conductive loop and axial segments are connected) including capacitive elements whereas the apparatus consists in four independent electrodes or coils without connected capacitive elements. Moreover, our invention is a resonant antenna where there is a sinusoidal current distribution in function of the azimutal angle which is not the case for the apparatus.

Further, WO 00/36632 A discloses inductive plasma antennas having axially displaced, electrically, interconnected, loop elements; and also capacitors within a loop element. There is, however, no magnetic field generator around the antenna, and no Helicon waves are generated.

The conjunction of the plasma source with a process chamber where workpieces are located to either deposit, or etch films or to sputter deposit films to the workpieces is known. This processing system comprises, in particular, external magnet components and RF coils in order to be used as an in situ Nuclear Magnetic Resonance. The use of nuclear magnetic resonance (NMR) for physical , chemical and biological studies is very well developed and highly successful [P.J. Hore, Nuclear Magnetic Resonance, Oxford University Press, Oxford, UK, 1995]. The application of NMR for Plasma diagnostic techniques has recently been undertaken [Zweben S.J. et al., 2003, Rev. Sci. Inst., 74, 1460] for Tokamak experiments. The application of NMR in low pressure and/or temperature plasma processes in particular for moisture monitoring, contamination monitoring, chamber characterizations , in order to reduce the troubleshooting time of the equipment and improve the quality of manufactured devices, is still quite innovative.

In accordance with the invention, there is provided a plasma source apparatus as defined in claim 1.

The invention uses one or multiple plasma source in conjunction with one or multiple process chamber to provide a high and uniform density over a large area inside the process chamber.

In another embodiment, the capacitive elements and/or moveable axial conductive elements of the antenna are tuned such that to increase the coupling between the RF energy and the plasma, defining an active antenna.

In another embodiment, the main components in the plasma source or in a process chamber can be used as an in situ monitoring of the environment inside the chamber or an in situ inspection ofworkpieces (such as wafer as part of semiconductor processes) based on the NMR principle.

### BRIEF DESCRIPTION OF THE DRAWINGS

FIG. 1 is a schematic view of an antenna arrangement according to the present invention
FIG. 2 is a schematic view of an antenna configuration in an another embodiment
FIG. 3 is a schematic view of the basic configuration of a plasma source
FIG. 4 is a schematic view of an antenna configuration where axial conductive elements are twisted
FIG. 5 is a schematic view of a configuration of a plasma reactor comprising antennae inside and outside the reactor, and an array of elementary magnets.
FIG. 6 is a schematic view of an antenna arrangement according to the present invention, with opened conductive loops

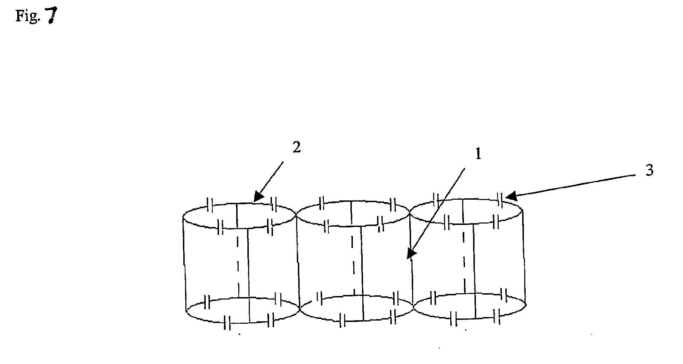

FIG. 7 is a schematic view of a network of antennas according to the present invention

### DEFINITIONS

Fluid : the term comprises gas, diphasic liquids , or supercritical gas
A Conductive loop : a conductive element which can be closed or opened, and which the shape can be circular, or elliptic, or with right angles.
A radio frequency generator : A device supplying continuous or pulsed RF power at one or several frequencies.
A process chamber : a chamber where happen plasma processings such as etching, deposition, sputtering, ion generation, sterilization or a chamber where inside one or several workpieces (wafer(s)) is placed for transfer, conditioning, stock prcessings.

### DETAILED DESCRIPTION

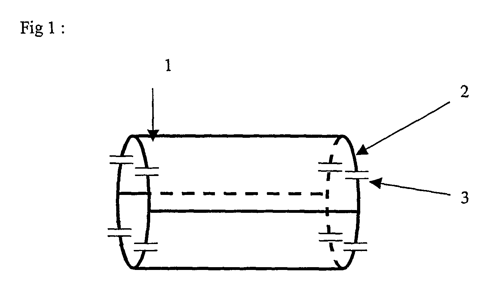

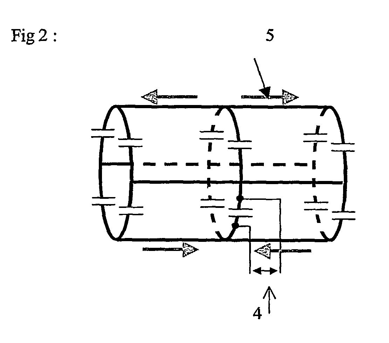

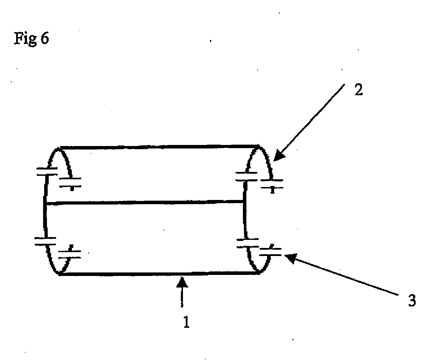

As can been seen on figures 1, 2, 4, and 6, the first principle structure of the present invention is the antenna configuration:
RF current is made to flow through at least a pair of conductive loops ( with any topology) 2 and axial conductive elements 1. In such a way that the current is passing in the case of the Figure 2 configuration according to 5. The RF voltage is applied from a RF power supply 4.

One feature of the coil concerns the excitation . Excitation of the RF coil at a single excitation point results in a linearly polarized magnetic field B. Quadrature excitation can be achieved in a straight forward manner using the coil described in one possible configuration (see Figure 1). This can be accomplished by exciting the coil at two input capacitors 3 located at right angles relative to one another along the circumference of one conductive loop elements 2. Additionally, to achieve the desired circular polarization, the RF sources used to excite the coil at two points must be electrically 90 degree out of phase relative to one another. In this manner, the two modes with approximately uniform transverse fields , as described above are excited.

A further feature of the antenna can be realized by utilizing multiple RF amplifiers to energize the antenna. Each amplifier is attached to different input capacitor, and the signal through each amplifier is phased correctly to produce the desired RF excitation. In this way, the power requirement from each amplifier is reduced as compared to the requirement for driving the antenna with one or two amplifiers.

The antenna can be made with a solid round wire , in copper for example , or with a conductor consisting of a number of separately insulated strands that are twisted or braided together. Since each strand tends to take all possible positions in the cross section of the entire conductor, this design equalizes the flux linkages - and reactances - of the individual strands causing the current to spread uniformly throughout the conductor. The primary benefit is the reduction of AC losses. An example of such construction are known as Litz wire.

It should be recognized that the multiple amplifier configurations described above are merely exemplary and many other combinations utilizing four or more amplifiers are possible.

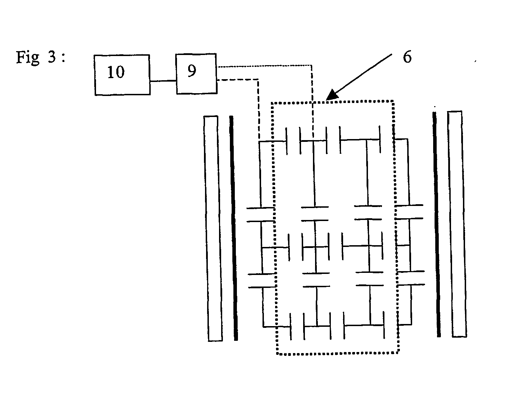

A basic configuration of the plasma source is shown on the Figure 3. with a Pyrex plasma generation chamber 6 surrounded by magnet field generators 8 placed on a pipe typically in PVC. The RF power 10 gives energy to the antenna through a matching network 9.

A major advantage of this antenna is that the current distribution appears to be zero for every mode m ≠ ±1. All the antenna power will be concentrated in those two modes. Experimentally the m=1 mode appears to be the more efficient for plasma heating with helicon waves. Another advantage is the high homogeneity of the plasma inside the chamber which can decrease significantly the damage on integrated circuits, increasing the yield of the manufacturing.

Especially in processing plasmas , the main features (density, electron temperature, ionic temperature, partial pressure species...) are dependent of the process time due to the interactions not only with the workpieces but also with the whole process chamber. That is why the possibility to adjust the coupling between the RF energy and the evolutive plasma allows high improvements of the process and the uptime of the equipment. We propose in another embodiment according the present invention to define an Active Antenna : where at least one capacitor is tunable and / or at least one conductive loop position is moveable, and / or at least one conductive loop rotation (→ twisted antenna) leading to a non zero angle between the axial conductive element's connexion on the first upper loop and the axial conductive element's connexion on the first lower loop, is moveable. A further configuration involves the feedback control of the active antenna according to sensors used as diagnostic techniques ( magnetic probe, optical probe, Langmuir probe, Hall probe...).

In another embodiment according to the present invention, the magnets can deliver magnetic amplitudes in function of time and/or space to perform peristaltic magnetic actions on the plasma defining in the plasma generation chamber successive areas of high and low density. This pattern can generate multiple double layers which are structures constituted by two adjacent sheaths of charge with opposite signs connecting different values of plasma potential through a monotic spatial potential profile.

In another embodiment according to the present invention, in order to enhance the performances of the plasma source it is possible to add close to the source a complementary source as Electron cyclotron resonance, ion cyclotron resonance or Electron Bernstein wave.

In another embodiment according to the present invention where frequency tuning is accomplished by mechanically moving a concentric RF shield about the longitudinal axis of an RF coil. Moving the shield about the RF coil effectively changes the mutual inductance of the system, providing a mechanism for adjusting the resonant frequency.

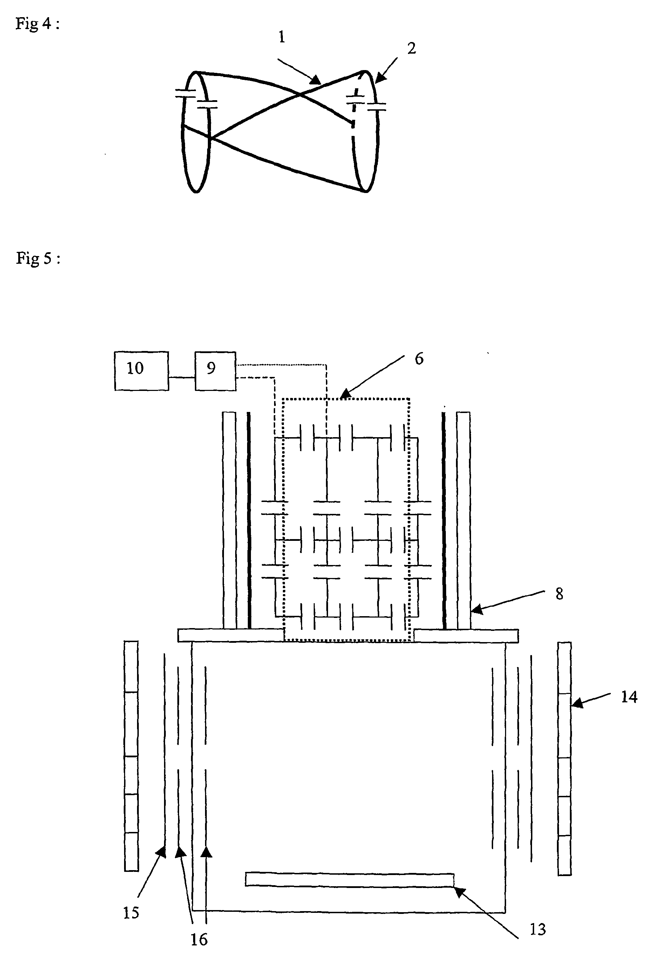

In another embodiment according to the present invention the plasma source is in conjunction with a process chamber (see Figure 5) comprising an array of magnets 14 , an array of RF coils outside the chamber walls 15, and an array of RF coils inside the chamber 16. The RF coils can be design as the one of the plasma source , that is to say with a plurality of capacitors. One part of the coils are used as feedback coils and the other part as sensor coils. It is possible to control the plasma stability by acquiring the coil sensor signal and , after treatment, to apply convenient current in order to improve the plasma behaviour. The sensors coils can be remplaced by other type of sensors (optical probe, Hall probe,...).

In another embodiment according to the present invention, series of electrodes are added inside the process chamber on which typically an oscillating voltage is applied. This action allows to confine the plasma and / or particles. The quadrupole electric fields of this trap exert radial forces on the charged particles that are analogous to radial forces that a periodic focusing quadrupole magnetic field exerts on charged particles.

In another embodiment according the present invention, we use the components of the process chamber ( array of magnets and arrays of RF coils) to proceed to an in situ monitoring by Nuclear Magnetic Resonance. Indeed, we can apply a transient pulse of RF field through one or more coils. After tuning off the pulse(s), the emitted energy is measured as an alternating voltage induced in the same coil(s). The amplitude of this NMR signal is proportional to number of resonant spins in the observed object (Chamber wall , workpieces ... ). But the absorbed excess energy is also dissipated due to interactions between the spins and their atomic and molecular environment as well as due to spin-spin interactions. These interactions are modulated in time by molecular motions giving rise to two relaxation processes. It leads for example that chemically combined water can be distinguished from water, which is physically bound to a solid surface and water, which is in the bulk liquid state. It is possible to improve the monitoring by a magnetic field strength, which defines a gradient in a specific direction.

These NMR monitoring allow to improve significantly the process ( before and after the plasma process, or after a preventive maintenance, it is possible to control the quality of the atmosphere, in particular the water rate), to optimise the uptime of the equipment and then the yield of the manufactured devices.

In another embodiment according to the present invention, the plasma source is coupled with an optical resonator to carry out a gas laser system by RF plasma. This device comprises a gas discharge tube made of quartz and sealed with two flat semi-transparent mirrors defining an optical resonator, the antenna of the present invention used in the presence of magnets to excite RF discharge. One of the mirrors can be mounted on a piezoelectric transducer. The mirrors are aligned to provide multiple reflections of lightwaves.

In another embodiment according to the present invention, the plasma source is couple with an apparatus generating acoustic cavitation bubbles, which act as nuclei for the ignition and maintenance of the plasma. Because the plasma is formed in a liquid environment, it is possible to obtain much higher film deposition rates or etching rates (it depends on chemical species involved) at much lower plasma temperatures than ever before. In addition this process can be carried out at normal temperatures and pressures. Previous combinations of ultrasonic waves and on one hand, microwave irradiation was performed by S.Nomura and H. Toyota, 2003, Applied Physics Letters, 83, 4503, and one the other hand, glow discharge engineered by Dow Coming Plasma. Here we propose to combine the ultrasonic waves with a RF plasma type.

The main applications where the present invention is relevant are : plasma processing (semiconductor manufacturing, Microtechnologies, nanotechnologies), Plasma welding, plasma-based sterilization, Plasma cutting, space propulsion, plasma abatment systems, academic research....

Although the invention has been described and illustrated with particularity, it is intended to be illustrative of preferred embodiments. It is understood that the disclosure has been made by way of example only. Numerous changes in the combination and arrangements of the parts, steps and features can be made by those skilled in the art without departing from the scope of the invention, as hereinafter claimed.

## Claims

1. A plasma source apparatus for plasma generation by Helicon waves comprising:
a. an antenna,
b. a plasma generation chamber (6) in the proximity of the antenna,
c. a fluid injector for introducing at least one fluid into the plasma generation chamber (6),
d. a radio frequency generator (10) with continuous or pulsed RF power supply (4), wherein
- the plasma source apparatus comprises magnetic field generators (8) arranged around the antenna,
- said antenna comprises at least two conductive loop elements (2) surrounding and spaced along a common longitudinal axis and at least a pair of axial conductive elements (1) electrically interconnecting said conductive loop elements (2),
- each of said conductive loop elements (2) including at least one capacitor (3).

2. Plasma source apparatus according to claim 1, wherein only said conductive loop elements (2) include at least one capacitor (3).

3. Plasma source apparatus according to claim 1, wherein said conductive loop elements (2) and said axial conductive elements (1) include at least one capacitor (3).

4. Plasma source apparatus according to anyone of the previous claims, comprising several axial conductive elements (1), each axial conductive element (1) interconnecting said conductive loop elements (2).

5. Plasma source apparatus according to anyone of the previous claims, comprising antenna cooling means such as a chiller, a heat pipe, a Cryo-cooler or a Peltier device.

6. Plasma source apparatus according to anyone of the previous claims, comprising thermal control means of the plasma generation chamber (6) in order to avoid thermal shock between the inside and the outside of the plasma generation chamber (6) during especially the plasma ignition.

7. Plasma source apparatus according to anyone of the previous claims, comprising a matching network (9) interconnecting the radio frequency generator (10) and the antenna, in such a way as to promote the optimal transfer of radio frequency energy from the radio frequency generator (10) to the antenna.

8. Plasma source apparatus according to anyone of the previous claims, comprising a fixed or moveable RF shield enclosing but disconnected from the antenna, for adjusting the resonant frequency of the antenna.

9. Plasma source apparatus according to claim 8, wherein the RF shield is adapted to define or to adjust in real time the optimal electromagnetic coupling between the antenna and the plasma.

10. Plasma source apparatus according to claim 8, wherein the RF shield (7) is a concentric RF shield about a longitudinal axis of the antenna, and wherein a frequency tuning is accomplished by mechanically moving the concentric RF shield along said axis.

11. Plasma source apparatus according to anyone of the previous claims, wherein at least one of said capacitors (3) is tunable.

12. Plasma source apparatus according to anyone of the previous claims, wherein at least one of said conductive loop elements (2) is movable.

13. Plasma source apparatus according to anyone of the previous claims, wherein the apparatus is adapted such that the antenna has a sinusoidal current distribution in function of the azimutal angle.

14. Plasma source apparatus according to anyone of the previous claims, coupled with an optical resonator comprising at least two mirrors, one partially reflecting, placed at the limits of the plasma generation chamber (6), the mirrors being aligned to provide multiple reflections of lightwaves.

15. Plasma source apparatus according to anyone of the previous claims, coupled with an apparatus for generating cavitation bubbles by ultrasonic waves, the plasma generation chamber (6) containing a liquid from where the bubbles are generated, the apparatus being adapted to induce RF energy into the interior of the acoustic cavitation bubbles for the ignition and the maintenance of the plasma.

16. Plasma source apparatus according to anyone of the previous claims, coupled with a complementary plasma source as Electron cyclotron resonance source or Ion cyclotron resonance source.

17. Plasma source apparatus according to anyone of the previous claims, coupled with a complementary antenna inside or outside the plasma generation chamber (6).

18. Plasma source apparatus according to anyone of the previous claims, wherein the antenna is also adapted as a receiving system to perform Nuclear Magnetic Resonance (NMR) Monitoring or analysis of fluid or a workpiece implemented inside the plasma generation chamber (6).

19. Plasma source apparatus according to anyone of the previous claims, wherein each of said axial conductive elements (1) and/or said conductive loop elements (2) are made with volume conductive wire, or braids wire, typically Litz wire, or hollow wire.

20. Plasma source apparatus according to anyone of the previous claims, comprising a network of antennas as defined in the previous claims, wherein adjacent pairs of conductive loop elements (2) have at least one common axial conductive element (1).

21. A plasma source apparatus according to anyone of the previous claims, being connected to one or a plurality of process chamber.

22. A plurality of plasma source apparatuses according to anyone of the previous claims, each plasma sources being cooperatively connected to at least one process chamber.

23. One or a plurality of plasma source apparatuses according to claims 21 or 22 comprising a plurality of RF coils (15, 16), the RF coils (15, 16) being arranged in a circumferential manner proximate to the process chamber or chambers.

24. One or a plurality of plasma source apparatuses according to the previous claims, wherein at least one RF coil (15, 16) comprises a capacitive element.

25. One or a plurality of plasma source apparatuses according to claims 21, 22, 23, or 24, comprising a plurality of magnets (14), the magnets (14) being arranged in a circumferential manner proximate to the process chamber or chambers, for example, to perform NMR inspection of the process chamber and/or the workpiece or workpieces inside.

26. One or a plurality of plasma source apparatuses according to claims 21, 22, 23, 24, or 25, comprising a plurality of electrodes defining a Paul trap type or a Penning trap type on which an oscillating voltage is applied.

27. Use of the plasma source apparatus or apparatuses according to anyone of the previous claims for in situ NMR monitoring of moisture, for example, or the in situ NMR inspection of a process chamber, or the in situ NMR analysis of workpieces, e.g. wafers, inside a process chamber.

28. Use of the plasma source apparatus or apparatuses according to anyone of claims 1-26, wherein the RF excitation is simultaneously applied on one or a plurality ports of the antenna, preferentially, on two ports of the antenna, where the difference between the two ports has a 90° degrees phase shift on the input excitation.

## Patentansprüche

1. - Ein Plasmaquellenapparat zur Plasmaerzeugung durch Helikonwellen, mit:
a. einer Antenne,
b. einer Plasmaerzeugungskammer (6) in der Nähe der Antenne,
c. einen Fluidinjektor zum Einbringen von mindestens einem Fluid in die Plasmaerzeugungskammer (6),
d. einen Hochfrequenzgenerator (10) mit kontinuierlicher oder gepulster HF-Energieversorgung (4), wobei
- der Plasmaquellenapparat Magnetfeldgeneratoren (8) enthält, die rings um die Antenne angeordnet sind,
- die Antenne mindestens zwei leitfähigen Schleifenelemente (2) aufweist, die eine gemeinsame Längsachse umgeben und entlang dieser im Abstand angeordnet sind, und mindestens ein Paar von axialen leitfähigen Elementen (1), die die leitfähigen Schleifenelemente (2) elektrisch miteinander verbinden,
- jedes der leitfähigen Schleifenelemente (2) mindestens einen Kondensator (3) enthält.

2. Plasmaquellenapparat nach Anspruch 1, wobei nur die leitfähigen Schleifenelemente (2) mindestens einen Kondensator (3) enthalten.

3. Plasmaquellenapparat nach Anspruch 1, wobei die genannten leitfähigen Schleifenelemente (2) und die genannten axialen leitfähigen Elemente (1) mindestens einen Kondensator (3) enthalten.

4. Plasmaquellenapparat nach irgendeinem der vorhergehenden Ansprüche, mit mehreren axialen leitfähigen Elementen (1), wobei jedes axiale leitfähige Element (1) die leitfähigen Schleifenelemente (2) miteinander verbinden.

5. Plasmaquellenapparat nach irgendeinem der vorhergehenden Ansprüche, mit Antennenkühlmitteln, wie z.B. einem Kühlaggregat, einem Wärmerohr, einem Cryo-Kühler oder einer Peltiereinrichtung.

6. Plasmaquellenapparat nach irgendeinem der vorhergehenden Ansprüche, mit thermischen Steuermitteln der Plasmaerzeugungskammer (6), um einen thermischen Schock zwischen der Innenseite und der Außenseite der Plasmaerzeugungskammer (6) insbesondere während der Plasmazündung zu vermeiden.

7. Plasmaquellenapparat nach irgendeinem der vorhergehenden Ansprüche, mit einem Anpassungsnetzwerk (9), das den Hochfrequenzgenerator (10) und die Antenne miteinander verbindet, derart, daß der optimale Transfer von Hochfrequenzenergie von dem Hochfrequenzgenerator (10) zu der Antenne gefördert wird.

8. Plasmaquellenapparat nach irgendeinem der vorhergehenden Ansprüche, mit einem festen oder beweglichen HF-Schirm, der die Antenne umgibt, aber von ihr getrennt ist, zum Einstellen der Resonanzfrequenz der Antenne.

9. Plasmaquellenapparat nach Anspruch 8, wobei der HF-Schirm ausgebildet ist, um in Echtzeit die optimale elektromagnetische Kopplung zwischen der Antenne und dem Plasma zu definieren oder einzustellen.

10. Plasmaquellenapparat nach Anspruch 8, wobei der HF-Schirm (7) ein konzentrischer HF-Schirm um die Längsachse der Antenne ist und wobei eine Frequenzabstimmung durch mechanische Bewegung des konzentrischen HF-Schirmes längs der genannten Achse durchgeführt wird.

11. Plasmaquellenapparat nach irgendeinem der vorhergehenden Ansprüche, wobei mindestens einer der Kondensatoren (3) abstimmbar ist.

12. Plasmaquellenapparat nach irgendeinem der vorhergehenden Ansprüche, wobei mindestens eines der leitfähigen Schleifenelemente (2) beweglich ist.

13. Plasmaquellenapparat nach irgendeinem der vorhergehenden Ansprüche, wobei der Apparat so ausgebildet ist, daß die Antenne eine sinusförmige Stromverteilung in Abhängigkeit von dem Azimut-Winkel hat.

14. Plasmaquellenapparat nach irgendeinem der vorhergehenden Ansprüche, der mit einem optischen Resonator gekoppelt ist, der mindestens zwei Spiegel enthält, von denen einer teilweise reflektierend ist, der an den Grenzen der Plasmaerzeugungskammer (6) plaziert ist, wobei die Spiegel ausgerichtet sind, um mehrfache Reflektionen von Lichtwellen zu liefern.

15. Plasmaquellenaparat nach irgendeinem der vorhergehenden Ansprüche, gekoppelt mit einem Apparat zum Erzeugen von Kavitationsblasen durch Ultraschallwellen, wobei die Plasmaerzeugungskammer (6) eine Flüssigkeit enthält, von der die Blasen erzeugt werden, wobei der Apparat so eingestellt ist, daß er HF-Energie im Inneren der akustischen Kavitationsblasen induziert, für das Zünden und die Aufrechterhaltung des Plasmas.

16. Plasmaquellenapparat nach irgendeinem der vorhergehenden Ansprüche, gekoppelt mit einer komplementären Plasmaquelle als Elektronen-Zyklotron-Resonanzquelle oder als Ionen-Zyklotron-Resonanzquelle.

17. Plasmaquellenapparat nach irgendeinem der vorhergehenden Ansprüche, gekoppelt mit einer komplementären Antenne innerhalb oder außerhalb der Plasmaerzeugungskammer (6).

18. Plasmaquellenapparat nach irgendeinem der vorhergehenden Ansprüche, wobei die Antenne auch angepaßt ist als ein Empfangssystem zur Durchführung von Kernmagnetresonanzüberwachung (NMR) oder Analyse von Fluid oder eines Werkstückes, die innerhalb der Plasmaerzeugungskammer (6) durchgeführt werden.

19. Plasmaquellenapparat nach irgendeinem der vorhergehenden Ansprüche, wobei jedes der genannten axialen leitfähigen Elemente (1) und/oder der genannten leitfähigen Schleifenelemente (2) aus volumenleitfähigem Draht oder geflochtenem Draht, typischerweise Litzendraht oder hohlem Draht hergestellt sind.

20. Plasmaquellenapparat nach irgendeinem der vorhergehenden Ansprüche mit einem Netzwerk von Antennen, wie in den vorhergehenden Ansprüchen definiert, wobei benachbarte Paare von leitfähigen Schleifenelementen (2) mindestens ein gemeinsames axiales leitfähiges Element (1) haben.

21. Ein Plasmaquellenapparat nach irgendeinem der vorhergehenden Ansprüche, der mit einer oder mehreren Prozeßkammern verbunden ist.

22. Eine Mehrzahl von Plasmaquellenapparaten gemäß irgendeinem der vorhergehenden Ansprüche, wobei jede der Plasmaquellen zusammenwirkend mit mindestens einer Prozeßkammer verbunden ist.

23. Ein oder mehrere Plasmaquellenapparate gemäß den Ansprüchen 21 oder 22 mit einer Vielzahl von HF-Spulen (15, 16), wobei die HF-Spulen (15, 16) in umgebender Weise nahe der Prozeßkammer oder den Prozeßkammern angeordnet sind.

24. Ein oder mehrere Plasmaquellenapparate nach den vorhergehenden Ansprüchen, wobei mindestens eine HF-Spule (15, 16) ein kapazitives Element enthält.

25. Ein oder mehrere Plasmaquellenapparate nach den Ansprüchen 21, 22, 23 oder 24 mit einer Vielzahl von Magneten (14), wobei die Magnete (14) in umgebender Weise nahe der Prozeßkammer oder den Prozeßkammern angeordnet sind, beispielsweise um eine NMR-Inspektion der Prozeßkammer und/oder des Werkstückes oder der Werkstücke innerhalb derselben durchzuführen.

26. Ein oder mehrere Plasmaquellenapparate nach den Ansprüchen 21, 22, 23, 24 oder 25 mit einer Vielzahl von Elektroden, die eine Paul-Falle oder eine Penning-Falle bilden, an die eine oszillierende Spannung angelegt wird.

27. Verwendung des Plasmaquellenapparates oder der Apparate gemäß irgendeinem der vorhergehenden Ansprüche für eine in situ NMR-Überwachung von Feuchtigkeit zum Beispiel oder einer in situ NMR-Inspektion einer Prozeßkammer oder in situ NMR-Analyse von Werkstücken, wie z.B. Wafern, innerhalb einer Prozeßkammer.

28. Verwendung eines Plasmaquellenapparates oder von Apparaten gemäß irgendeinem der Ansprüche 1 bis 26, wobei die HF-Erregung gleichzeitig an einen oder an mehrere Anschlüsse der Antenne angelegt wird, vorzugsweise an zwei Anschlüsse der Antenne, wobei die Differenz zwischen den beiden Anschlüssen eine Phasenverschiebung der Eingangserregung von 90° hat.

## Revendications

1. Appareil à source de plasma pour la génération d'un plasma par des ondes Helicon, comprenant :
a - une antenne,
b - une chambre de génération de plasma (6) à proximité de l'antenne,
c - un injecteur de fluide pour introduire au moins un fluide à l'intérieur de la chambre de génération de plasma (6),
d - un générateur radio fréquence (10) ayant une alimentation (4) de puissance RF continue ou pulsée, dans lequel
- l'appareil à source de plasma comprend des générateurs de champ magnétique (8) disposés autour de l'antenne,
- ladite antenne comprend au moins deux éléments conducteurs en boucle (2) entourant et étant espacés le long d'un axe longitudinal commun et au moins une paire d'éléments conducteurs axiaux (1) interconnectant électriquement lesdits éléments conducteurs en boucle (2),
- chacun desdits éléments conducteurs en boucle (2) comprenant au moins un condensateur (3).

2. Appareil à source de plasma selon la revendication 1, dans lequel seulement lesdits éléments conducteurs en boucle (2) comprennent au moins un condensateur (3).

3. Appareil à source de plasma selon la revendication 1, dans lequel lesdits éléments conducteurs en boucle (2) et lesdits éléments conducteurs axiaux (1) comprennent au moins un condensateur (3).

4. Appareil à source de plasma selon l'une quelconque des revendications précédentes, comprenant plusieurs éléments conducteurs axiaux (1), chaque élément conducteur axial (1) interconnectant lesdits éléments conducteurs en boucle (2).

5. Appareil à source de plasma selon l'une quelconque des revendications précédentes, comprenant des moyens de refroidissement d'antenne tels qu'un refroidisseur, un caloduc, un refroidisseur Cryogénique ou un dispositif Peltier.

6. Appareil à source de plasma selon l'une quelconque des revendications précédentes, comprenant des moyens de commande de la température de la chambre de génération de plasma (6) de manière à éviter tout choc thermique entre l'intérieur et l'extérieur de la chambre de génération de plasma (6) principalement pendant l'allumage du plasma.

7. Appareil à source de plasma selon l'une quelconque des revendications précédentes, comprenant un réseau d'adaptation (9) interconnectant le générateur de radiofréquence (10) et l'antenne, de façon à favoriser le transfert optimal d'énergie radiofréquence depuis le générateur radiofréquence (10) vers l'antenne.

8. Appareil à source de plasma selon l'une quelconque des revendications précédentes, comprenant un écran RF fixe ou déplaçable enveloppant mais étant déconnecté de l'antenne, pour ajuster la fréquence de résonance de l'antenne.

9. Appareil à source de plasma selon la revendication 8, dans lequel l'écran RF est adapté pour définir ou pour ajuster en temps réel le couplage électromagnétique optimal entre l'antenne et le plasma.

10. Appareil à source de plasma selon la revendication 8, dans lequel l'écran RF (7) est un écran RF concentrique autour d'un axe longitudinal de l'antenne, et dans lequel un réglage de fréquence est réalisé par un déplacement mécanique de l'écran RF concentrique le long dudit axe.

11. Appareil à source de plasma selon l'une quelconque des revendications précédentes, dans lequel au moins l'un desdits condensateurs (3) est réglable.

12. Appareil à source de plasma selon l'une quelconque des revendications précédentes, dans lequel au moins l'un desdits éléments conducteurs en boucle (2) peut être déplacé.

13. Appareil à source de plasma selon l'une quelconque des revendications précédentes, dans lequel l'appareil est adapté de sorte que l'antenne présente une distribution sinusoïdale de courant en fonction de l'angle azimutal.

14. Appareil à source de plasma selon l'une quelconque des revendications précédentes, couplé avec un résonateur optique comprenant au moins deux miroirs, un partiellement réfléchissant, placés aux limites de la chambre de génération de plasma (6), les miroirs étant alignés pour fournir des réflexions multiples d'ondes lumineuses.

15. Appareil à source de plasma selon l'une quelconque des revendications précédentes, couplé avec un appareil pour générer des bulles de cavitation par des ondes ultrasoniques, la chambre de génération de plasma (6) contenant un liquide à partir duquel les bulles sont générées, l'appareil étant adapté pour générer une énergie RF à l'intérieur des bulles de cavitation acoustiques pour l'allumage et le maintien du plasma.

16. Appareil à source de plasma selon l'une quelconque des revendications précédentes, couplé avec une source plasma complémentaire telle une source à résonance cyclotron Electron ou une source de résonance cyclotron Ion.

17. Appareil à source de plasma selon l'une quelconque des revendications précédentes, couplé avec une antenne complémentaire à l'intérieur ou à l'extérieur de la chambre de génération de plasma (6).

18. Appareil à source de plasma selon l'une quelconque des revendications précédentes, dans lequel l'antenne est également adaptée comme système de réception pour réaliser par Résonance Magnétique Nucléaire (RMN) un suivi ou une analyse de fluide ou d'une pièce à traiter implémentée à l'intérieur de la chambre de génération de plasma (6).

19. Appareil à source de plasma selon l'une quelconque des revendications précédentes, dans lequel chacun desdits éléments conducteurs axiaux (1) et/ou desdits éléments conducteurs en boucle (2) est réalisé avec un fil conducteur en volume, ou un fil tressé, typiquement un fil Litz, ou un fil creux.

20. Appareil à source de plasma selon l'une quelconque des revendications précédentes, comprenant un réseau d'antennes telles que définies dans les revendications précédentes, dans lequel des paires adjacentes d'éléments conducteurs en boucle (2) présentent au moins un élément conducteur axial (1) en commun.

21. Appareil à source de plasma selon l'une quelconque des revendications précédentes, étant connecté à une ou plusieurs chambres de traitement.

22. Pluralité d'appareils à source de plasma selon l'une quelconque des revendications précédentes, chaque source de plasma étant interconnectée de façon coopérative à au moins une chambre de traitement.

23. Un ou plusieurs appareils à source de plasma selon les revendications 21 ou 22, comprenant une pluralité de bobines RF (15, 16), les bobines RF (15, 16) étant disposées d'une manière circonférentielle à proximité de la chambre ou des chambres de traitement.

24. Un ou plusieurs appareils à source de plasma selon l'une quelconque des revendications précédentes, dans lequel au moins une bobine RF (15, 16) comprend un élément capacitif.

25. Un ou plusieurs appareils à source de plasma selon les revendications 21, 22, 23, ou 24, comprenant une pluralité d'aimants (14), les aimants (14) étant disposés d'une manière circonférentielle à proximité de la chambre ou des chambres de traitement, par exemple, pour réaliser une inspection RMN de la chambre de traitement et/ou de la pièce à traiter ou des pièces à traiter à l'intérieur.

26. Un ou plusieurs appareils à source de plasma selon les revendications 21, 22, 23, 24 ou 25, comprenant une pluralité d'électrodes définissant un piège du type Paul ou un piège du type Penning sur lequel on applique une tension oscillante.

27. Utilisation d'un appareil ou d'appareils selon l'une quelconque des revendications précédentes pour le suivi RMN in situ de l'humidité, par exemple, ou l'inspection RMN in situ d'une chambre de traitement, ou pour l'analyse RMN in situ de pièces à traiter, par exemple de plaques, à l'intérieur d'une chambre de traitement.

28. Utilisation d'un appareil ou d'appareils selon l'une quelconque des revendications 1-26, au cours de laquelle l'excitation RF est appliquée simultanément à un ou à une pluralité de ports de l'antenne, de façon préférentielle, à deux ports de l'antenne, où la différence entre les deux ports présente un décalage de phase de 90° degrés sur l'excitation d'entrée.
